# EUROPEAN PATENT APPLICATION

(11) **EP 2 107 384 A1**
(43) Date of publication of application: **07.10.2009**
(21) Application number: 08103183.3
(22) Date of filing: 31.03.2008
(51) Int. Cl.: G01R 31/12

(54) **Determining degraded insulating ability in an inductively operating element**

(71) Applicant: ABB Research Ltd., 8050 Zürich (CH)
(72) Inventor: Gäfvert, Uno, 723 49, Västerås (SE)
(74) Representative: Dahlstrand, Björn

(57) **Abstract**

The present invention relates to a method, device (10) and computer program product for determining the change in insulating ability of the insulation provided around a conductor (18) of an inductively operating element (16), which conductor is wound a number of turns. The device (10) includes a signal generating unit (12) that applies a signal of varying frequency to the conductor (18) and an analyzing unit (14), which receives a frequency response to said signal from the conductor, compares the received frequency response with a reference frequency response and determines the change in insulating ability based on the comparison.

## Description

### FIELD OF INVENTION

The present invention relates to a method, device and computer program product for determining the change in insulating ability of the insulation provided around a conductor of an inductively operating element.

### BACKGROUND

The insulation of inductively operating elements, for instance the insulation provided around windings of transformers may degrade with time, for instance because this insulation, which in many high-voltage applications is made of paper or pressboard, is contaminated with a contaminant, for instance in the form of Copper Sulphide (Cu₂S). In order to be able to provide suitable countermeasures, it is then of interest to determine the amount of degradation of the insulating ability. This may be done in order to know when the element in question is to be replaced and/or serviced. A better knowledge of the insulating ability can be of high economic importance. Through such knowledge it is furthermore easier to determine when an element is to be disconnected, which may also be of advantage from a safety point of view.

It has not yet been possible to do this in any good way without having to disassemble the element and directly inspect the insulating material. This is both cumbersome and time consuming. The element can of course also not be used during such investigation. There is furthermore a risk that the element will be destroyed by the disassembly.

There exist within the field a variety of inspection methods.

In for instance US 5,440,238 there is described an apparatus and method for detecting, determining, and imaging surface resistance corrosion, thin film growth, and oxide formation on the surface of conductors or dielectric. The device comprises a modified confocal resonator structure with a sample remote from the radiating mirror. Surface resistance is determined by analyzing and imaging reflected microwaves. Imaging then reveals anomalies due to surface impurities, non-stoichiometry, and the like, in the surface of the conductor or dielectric.

In JP 04176108 there is described a detection member, on the surface of which metal particles are dispersed. The particles are provided in such a manner that they are brought into contact with insulating oil with which a main body of an electric machine is insulated. The change of electric resistance of the detection member is recognized. For example, a sulfide detecting part may be dipped in the insulating oil that is provided in a tank of an oil-immersed transformer, and the sulfide detecting part is connected to a connection wire via an insulating terminal. Copper powder is blown against one surface of a rectangular epoxy resin insulating plate and it is dispersely adhered thereto. An electrode is provided on both ends of the insulating plate, and leads are connected. As a result, the electric resistance on the surface of the insulating plate decreases when conductive copper sulfate is dispersely adhered to the surface of the insulating plate, and the degree of growth of copper sulfate can be recognized by measuring the change of electric resistance between the two leads.

In JP 07335446 an insulating oil and a copper plate are sealed in a vessel and heated at a certain temperature during a certain time interval. Thereafter the sulfide corrosion of the insulating oil is diagnosed through adding the dissolved copper to the sulfuric acid ion content in relation to the produced copper sulfide on the copper surface. The insulating oil is also extracted from the oil-filled electric equipment in operation in order to measure the dissolved copper and the sulfuric acid ion content as well as in order to compute the production density of the produced copper sulfide in order to diagnose the sulfide corrosion.

In JP 57141565 a tap switch is connected in series with an internal winding of a transformer and connected to an external terminal. The winding resistance of the transformer is measured by inserting a measuring current through the external terminal while switching the tap switch. The current is less than or equal to 0.5 A. Then the winding resistance value of this measurement is compared with the winding resistance value in a normal mode. Through the measurement it is determined that a sulphurization process progresses considerably in case the measured winding resistance value is larger than in normal mode.

It is known to analyze the insulating ability of insulation between different windings using dielectric frequency response methods. Examples of this are given below.

US 7,292,048 describes a method and device for measuring a dielectric response of an electrical insulating system, where a first measurement result is determined by a frequency domain method and a second measurement result is determined by a time domain method. The first measurement result and the second measurement result are combined to form an overall measurement result as the dielectric response.

US 6,870,374 describes a method for identifying a type of abnormality in an insulation system of a power transformer, where dielectric losses in a section of the insulation system are measured, theoretical dielectric losses for the section are calculated based on the material properties, geometry, and temperature of the section, and a graphical representation of a percent difference between the measured and calculated dielectric losses is generated.
In "Dielectric Frequency Response Measurement as a Tool for Troubleshooting Insulation Power Factor Problems", Mark Perkins, Asim Fazlagic, George Frimpong, Conference Record of the 2002 IEEE International Symposium on Electrical Insulation, Boston, MA USA, April 7-10, 2002, there is described a method for evaluating the dielectric frequency response (DFR) test for troubleshooting and identifying the cause of high or unusual insulation power factor test results. In the method a dielectric response signature is prepared from the DFR test on a transformer. The signature and measured response is compared with a modeled response of a transformer with a "normal" insulating structure and a library of signatures of known defects. Based on the comparison power factor defects in the insulation structure of the transformer under test can be diagnosed.

"Frequency response of oil impregnated pressboard and paper samples for estimating moisture in transformer insulation", Chandima Ekanayake, Stanislaw M. Gubanski, Andrzej Graczkowski, Krzysztof Walczak, IEEE Transactions on Power Delivery, vol. 21, no. 3, July 2006, describes the frequency domain spectra of oil impregnated pressboard and paper samples, which can be used in modeling of results of diagnostic measurements in power transformers.

"Evaluation of Transformer Insulation by Frequency Domain Technique" P.K. Poovamma, A. Sudhindra, K.Mallikarjunappa, T.R. Afzal Ahamad, 2007 International Conference on Solid Dielectrics, Winchester, UK, July 8-13, 2007, discusses measurements of dielectric response being used for assessing the paper-oil insulating system in transformers.

"Dielectric Response Analysis of Real Insulation Systems", Uno Gafvert, 2004 International Conference on Solid Dielectrics, Toulouse, France, July 5-9, 2004 discusses application of dielectric frequency response methods to a number of practically important real insulation system.

However none of these documents describe frequency response analysis for determining the degradation of the insulation provided around a conductor in an inductively operating element.

### SUMMARY OF THE INVENTION

The present invention is directed towards providing a solution to the problem of determining the change in insulating ability of the insulation provided around a conductor of an inductively operating element without having to disassemble the element.

This problem is generally solved through applying a signal of varying frequency to the conductor of the inductively operating element, which conductor is wound a number of turns, receiving a frequency response to the signal from the conductor, comparing the received frequency response with a reference frequency response and determining the change in insulating ability based on the comparison.

One object of the present invention is to provide a method for determining the change in insulating ability of the insulation provided around a conductor of an inductively operating element, which method can be performed without having to disassemble the element.

This object is according to a first aspect of the present invention solved through a method of determining the change in insulating ability of the insulation provided around a conductor of an inductively operating element, which conductor is wound a number of turns, and comprising the steps of:
- applying a signal of varying frequency to the conductor of the inductively operating element,
- receiving a frequency response to the signal from the conductor,
- comparing the received frequency response with a reference frequency response, and
- determining the change in insulating ability based on the comparison.

Another object of the present invention is to provide a device for determining the change in insulating ability of the insulation provided around a conductor of an inductively operating element, which can perform this determination without having to disassemble the element.

This object is according to a second aspect of the present invention solved through a device for determining the change in insulating ability of the insulation provided around a conductor of an inductively operating element, which conductor is wound a number of turns, and comprising
- a signal generating unit arranged to apply a signal of varying frequency to the conductor of the inductively operating element,
- an analyzing unit arranged to
   - receive a frequency response to said signal from said conductor,
   - compare the received frequency response with a reference frequency response, and
   - determine the change in insulating ability based on the comparison.

Another object of the present invention is to provide a computer program product for determining the change in insulating ability of the insulation provided around a conductor of an inductively operating element, which allows this determination to be performed without having to disassemble the element.

This object is according to a third aspect of the present invention solved through a computer program product for determining the change in insulating ability of the insulation provided around a conductor of an inductively operating element, which conductor has being wound a number of turns, and comprising computer program code provided on a computer readable medium and being configured to make a computer perform, when said code is loaded into said computer
- receive, from the conductor of the inductively operating element, a frequency response to a signal of varying frequency that has been applied to said conductor of the inductively operating element,
- compare the received frequency response with a reference frequency response, and
- determine the change in insulating ability based on the comparison.

According to one variation of the present invention the comparison is performed through comparing a peak in the received frequency response with a corresponding peak in the reference frequency response and the determination of the change in insulating ability is based on a difference in shape between the peaks, where both peaks correspond to a resonance frequency caused by the wound conductor.

The difference in shape may, according to some variations of the present invention, be a difference in peak values of peaks and/or a difference in width of a given fraction of peak values of the peaks.

The present invention has a number of advantages. It determines the degradation of the insulating ability of the insulation without disassembling or in other ways negatively influencing the inductively operating element. Through such a determination it is then easier to determine a service activity to be performed on the element, such as when it is to be replaced, repaired and/or serviced. A better knowledge of the insulating ability can therefore be of high economic importance. Through such knowledge it is furthermore easier to determine when an element is to be disconnected, which may also be of advantage from a safety point of view.

### BRIEF DESCRIPTION OF THE DRAWINGS

The present invention will in the following be described with reference being made to the accompanying drawings, where
fig. 1 schematically shows the device according to the present invention being connected to a primary winding of a transformer,
fig. 2 schematically shows a sectional view through one half of an exemplifying transformer,
fig.3 schematically shows a view from above of the whole transformer in fig. 2,
fig. 4 shows an exemplifying reference frequency response associated with the primary winding of the transformer,
fig. 5 shows an exemplifying frequency response to a signal of varying frequency that has been applied to the primary winding of the transformer, and
fig. 6 schematically shows a number of method steps being taken in a method according to the present invention.

### DETAILED DESCRIPTION OF THE INVENTION

In the following, a detailed description of preferred embodiments of a device and a method according to the present invention will be given.

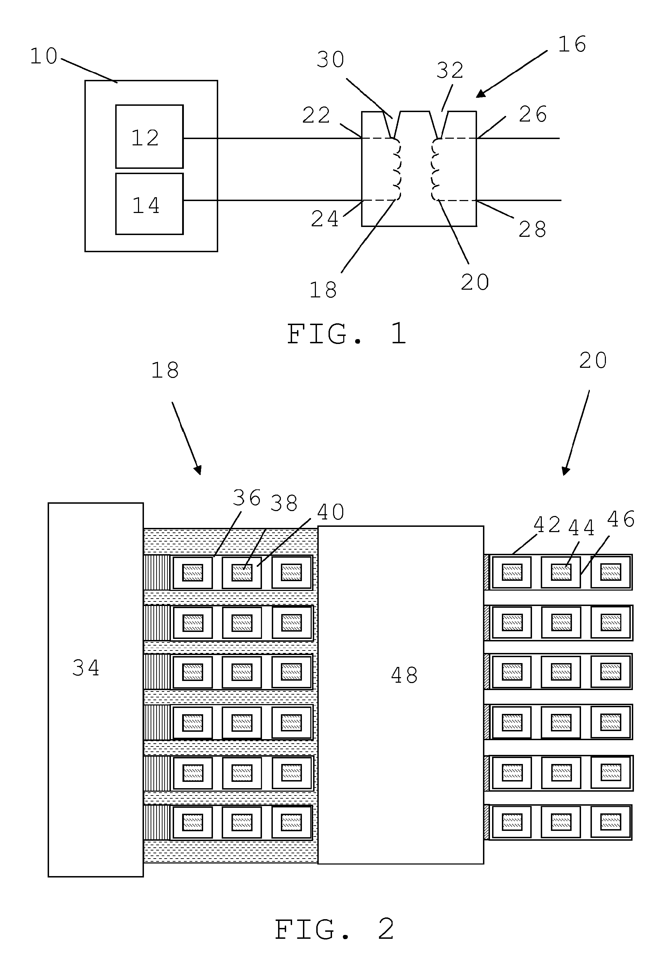

In fig. 1 there is shown a device 10 for determining the change in insulating ability of the insulation provided around a conductor of an inductively operating element. The device 10 of the present invention includes a signal generating unit 12 and an analyzing unit 14. The signal generating unit 12 is here arranged to be connected to a terminal of an inductively operating element and the analyzing unit is also arranged to be connected to a terminal of the same inductively operating element.

In fig. 1 the device 10 is connected to an inductively operating element that is here in the form of a transformer 16. The transformer 16 in fig. 1 is schematically shown as including a primary winding 18 and a secondary winding 20. The transformer 16 does furthermore have a number of terminals, a first and second feeding terminal 22 and 24 for connection to the primary winding 18 and a third and fourth feeding terminal 26 and 28 for connection to the secondary winding 20. The transformer 16 shown in fig. 1 does furthermore include a fifth and sixth terminal 30 and 32, where the fifth terminal 30 is arranged through a bushing tap that provides connectivity to the primary winding 18 and the sixth terminal 32 is arranged through a bushing tap that provides connectivity to the secondary winding 20.

In the example given here the signal generating unit 12 is connected to the first feeding terminal 22 and the analyzing unit 14 is connected to the second feeding terminal 24, i.e. the device 10 is connected to both ends of the conductor that makes up the primary winding 18. It should be realized that this is just one way in which the device 10 may be connected to the transformer 16 and that several other ways exist, which will be described in more detail later on.

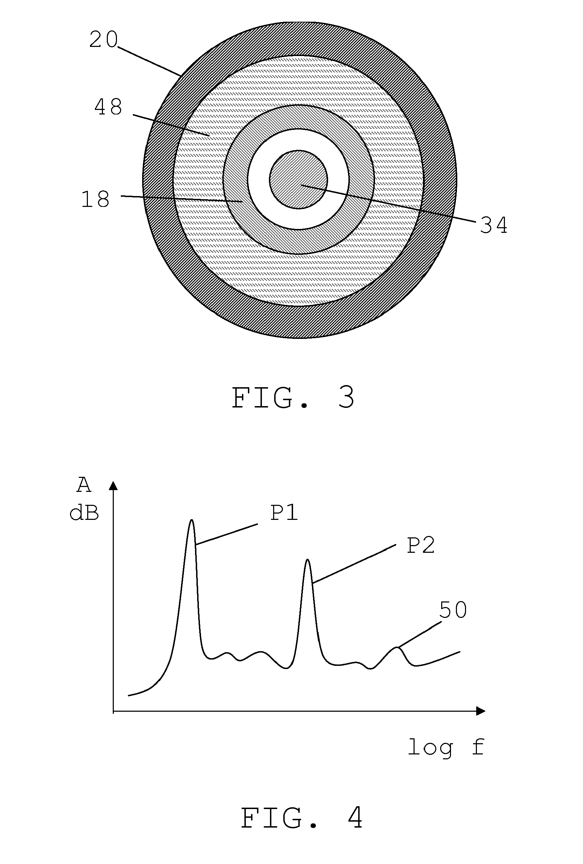

Fig. 2 shows a sectional view of half a transformer and fig. 3 shows a view as seen from above of a whole transformer on which measurements according to the present invention may be made.

The transformer is with advantage a power transformer, i.e. a transformer that may operate at high voltages typically in the kV range. With such large transformers it is known to provide both the primary and secondary sides windings as a conductor 38 and 44, which is surrounded by insulating material 40 and 46. The insulating material is in many cases paper or pressboard, which may be soaked in oil. The primary winding 18 is furthermore often wound concentrically around a transformer core 34. In this case the conductor that forms the primary winding 18 is wound in the form of bands, where one band includes a number of turns of the conductor, in the example of fig. 2 three. The turns 38 of a band 36 are wound around the core 34 aligned with each other vertically but displaced from each other horizontally. Either the innermost turn or the outermost turn of the lowest or highest band in the vertical direction is here connected to the innermost turn of a neighboring band. In the intermediate bands both the innermost and outermost turn is connected to a neighboring band. A winding, for instance the primary winding 18 thus includes a number of bands 36 provided around the core vertically displaced from each other. Each band 36 thus includes a number of horizontally displaced turns 38 of conductor, where the whole conductor, and thus each turn 38 of the conductor is surrounded by insulation 40. Each such conductor in a band furthermore faces a neighboring conductor of a neighboring band in the vertical direction.

The secondary winding 20 is provided concentrically around the core in the same way as the primary winding 18, using bands including horizontally displaced turns and where these bands are vertically displaced from each other. There is furthermore normally provided insulating material 48, which may also be provided through oil-soaked paper or pressboard, between the primary and secondary winding.

With such a structure it is evident that the conductor that makes up the primary winding cannot only be seen as a "pure" inductance, but rather that there is capacitive coupling between horizontally displaced conductor sections in each band as well as capacitive coupling between vertically displaced conductor sections in neighboring bands. This means that the primary winding can be characterized by a model that provides an "LC"-circuit, which does have resonance at one or more resonance frequency determined by the inductances and capacitances of this model of the winding. It is thus clear that the way the primary winding is wound can be characterized by a model providing an "LC"-circuit having one or more resonances. The way the winding has been made thus causes the existence of resonances. It should be realized that a corresponding model may be provided also for the secondary winding.

Now, as such a transformer is being used for a long time, it will be degraded. One type of degradation that may typically occur is that the insulation of the conductor making up a winding of a transformer, will receive impurities, such as Copper Sulphide (Cu₂S). Such impurities will degrade the insulating ability of the insulation, i.e. it will in some sense conduct current or cause intense local losses. This is the same as inserting resistances into the model of the winding that was described above. This will furthermore provide the above-described model with resistances in parallel with the capacitances. This also means that the functioning of the transformer will be influenced and that it may at some time have to be repaired or replaced.

The present invention is directed towards determining the degradation of the insulating ability of the insulation around a winding in for instance a transformer. Because of such a determination it is then easier to determine when service, repair or replacement may be made of such a transformer through investigating the resistive character of the above-described model.

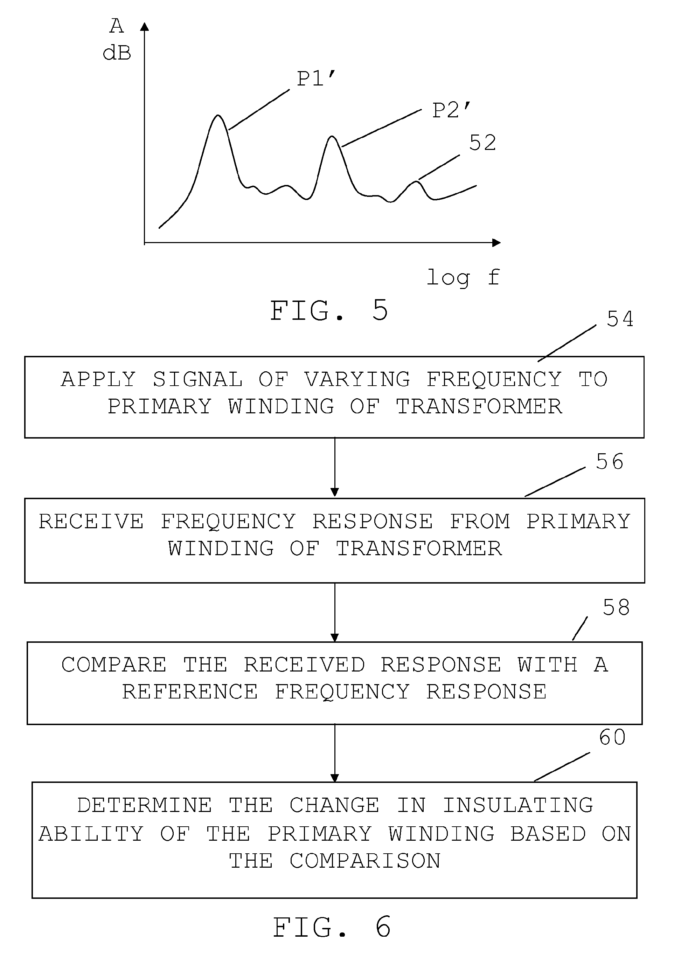

The functioning of the present invention will now be described in more detail with reference also being made to fig. 4, 5 and 6, where fig. 4 shows an exemplifying reference frequency response, fig. 5 shows an exemplifying frequency response to a signal of varying frequency that has been applied to the primary winding of the transformer, and fig. 6 schematically shows a number of method steps being taken in a method according to the present invention. The frequency responses are in fig. 4 and 5 shown as curves 50 and 52 provided in diagrams having X- and Y-axes, where the Y-axes show a signal amplitude A in dB and the X-axes show the frequency in logarithmic form, i.e. as log f. The exemplifying frequency response curves 50 and 52 furthermore each have a first P1, P1' and a second P2, P2' peak provided at two different frequencies, which frequencies are the same for the two curves 50 and 52. These peaks correspond to resonance frequencies of the primary winding.

The method starts with the signal generating unit 12 of the device 10 applying a signal of varying frequency to the primary winding 18 of the transformer 16, step 54, which may be done through sending a frequency sweeping signal into the first feeding terminal 22 of the primary winding 18 of the transformer 16. This signal is preferably a sinusoidal signal having an amplitude and which is swept in a high-frequency spectrum, i.e. a spectrum covering one or more of the resonance frequencies of the winding. This frequency range may typically be a range between 10 kHz and 10 MHz. As an alternative it is possible to apply a signal made up of pulses, where these pulses include a frequency content that is sufficient for obtaining a frequency response in the desired frequency range. The frequency sweeping signal passes through the primary winding 18 and generates a response 52 at the second feeding terminal 24. The response 52 is received by the analyzing unit 14, step 56, thereby providing a frequency response 52 having a particular frequency spectrum. The analyzing unit 14 may here store the received frequency response 52 in a memory as well as present it, perhaps together with a reference frequency response 50 also having a particular frequency spectrum, in order to determine if there is a change in the insulating ability of the insulating material of the primary winding 18.

The analyzing unit 14 does therefore compare the received frequency response 52 with a reference frequency response 50, step 58, and determines the change in insulating ability of the insulation provided around the primary winding 18 based on the comparison, step 60. Here the reference frequency response 50 may be a frequency response that has been determined mathematically based on the above-described LC model of the primary winding or it may be an actual measured frequency response that may have been obtained when the transformer was assembled in factory or first put to use. It is of course also possible that the reference frequency response may be obtained at some other time through suitable measurements.

The comparison may in more detail be performed in the following way. It may be done through comparing a peak P1' in the received frequency response 52 with a peak P1 in the reference response 50, where both these peaks P1' and P1 correspond to one resonance frequency of the primary winding 18. This resonance frequency will thus also be possible to be obtained via analysis of the equivalent LC circuit of the above-described model. The difference in shape of these peaks P1 and P1' can then be used for determining the degraded insulating ability.

One way in which the difference in shape may be used involves comparing actual peak values of these peaks. The amount that the peak value of the peak P1' in the received frequency response 52 is lower than the corresponding peak value of the peak P1 in the reference frequency response 50 can then be used to indicate a resistive value in the model, which resistive value may then directly relate to the degradation of the insulating ability. The degradation in insulating ability of the insulation around the conductor may therefore be obtained through this peak value difference.

It is also, instead of or in addition to comparing peak values, possible to use a Q or full width at half maximum (FWHM) type of criterion. It is thus possible to compare the width for a given fraction, for instance half, of the peak value of a peak P1' in the received frequency response 52 with a corresponding width for the same fraction of the peak value of the corresponding peak P1 in the reference frequency response 50. In case the width of the peak P1' in the received frequency response 52 is wider than the width of the reference peak P1 in the reference response 50, this may be used to indicate a resistive character and thus a degraded insulating ability of the insulation of the primary winding. The degradation in insulating ability may therefore be obtained through this width difference.

It is furthermore possible to perform the same types of analysis on even more peaks in the received and reference responses, for instance on peaks P2' and P2 in fig. 4 and 5, where both these peaks P2' and P2 correspond to a second resonance frequency.

In this way it is possible to determine the degradation of the insulating ability of the insulation provided around the primary winding of the transformer. This can furthermore be done without disassembling or in other ways negatively influencing the transformer. Through such a determination it is then easier to determine a service activity to be performed on the transformer, such as when it is to be replaced, repaired and/or serviced. A better knowledge of the insulating ability can therefore be of high economic importance. Through such knowledge it is furthermore easier to determine when an element is to be disconnected, which may also be of advantage from a safety point of view as well as of a power delivery point of view. The above mentioned determination may of course be combined with other types of determinations in order to determine service activities, such as investigating moisture in the insulation and ageing of oil in insulations.

The device according to the present invention may be provided through a suitable programmed network analyzer (NA) or computer. The method steps being provided by the analyzing unit of the present invention may in fact be provided in the form of a computer program product comprising computer program code provided on a computer readable medium, such on a CD ROM or other type of storage medium, and being configured to make a computer or a network analyzer perform, when said code is loaded into said computer or network analyzer, the method steps described above in relation to the analyzing unit.

The present invention may be varied in a number of ways. It should first of all be realized that the signal of varying frequency may be applied to the second feeding terminal instead of the first feeding terminal and the result received from the first feeding terminal. It is furthermore possible that either the first or the second feeding terminal may not be accessible. In that case it is possible that the signal is applied to the accessible feeding terminal and the response received via the same terminal, and thereafter analyzed, for instance using a reflection spectrum from the winding. It should furthermore be realized that the first bushing tap may also be used, either as a terminal to which the signal of varying frequency is applied or via which the response is received or both. A similar type of analysis may of course also be performed on the secondary winding. The analyzing unit may furthermore emit a warning signal if one or more of the received response values, like width and peak values, differ from the reference values more than a corresponding pre-set value. The invention can thus be used together with alarm thresholds.

The inductively operating element analyzed that was exemplified above was a transformer. It should be realized that a transformer analyzed in this way may be any type of transformer, for instance a three-phase power transformer. Such analysis may therefore be performed on all windings of such a transformer. However, the invention is not limited to being applied to transformers. It can be applied on any inductively operating element, for instance on an inductor. From the foregoing discussion it is evident that the present invention can be varied in a multitude of ways. It shall consequently be realized that the present invention is only to be limited by the following claims.

## Claims

1. A method for determining the change in insulating ability of the insulation provided around a conductor (18) of an inductively operating element (16), which conductor is wound a number of turns (38), and comprising the steps of:
- applying (54) a signal of varying frequency to the conductor of the inductively operating element,
- receiving (56) a frequency response (52) to said signal from said conductor,
- comparing (58) the received frequency response (52) with a reference frequency response (50), and
- determining (60) the change in insulating ability based on the comparison.

2. A method according to claim 1, wherein the step of comparing the frequency response with a reference frequency response comprises comparing a peak (P1') in the received frequency response (52) with a corresponding peak (P1) in the reference frequency response (50) and the step of determining the change in insulating ability comprises determining the change in insulating ability based on a difference in shape between the peaks, where both peaks correspond to a resonance frequency caused by the wound conductor.

3. A method according to claim 2, wherein a lower peak value in the peak of the received frequency response than in the corresponding peak of the reference frequency response indicates a degraded insulating ability.

4. A method according to claim 2 or 3, wherein a larger width for a given fraction of the peak value of the peak in the received frequency response in relation to the width of the same fraction of the peak value of the corresponding peak in the reference frequency response indicates a degraded insulating ability.

5. A method according to any of claims 2 - 4, wherein the change is determined through comparing more than one peak (P1', P2') in the received frequency response (52) with corresponding peaks (P1, P2) in the reference frequency response (50), where each such peak in a frequency response being compared corresponds to a different resonance frequency.

6. A method according to any previous claim, wherein the step of applying comprises applying the signal of varying frequency to a feeding terminal (22) of the conductor and the step of receiving comprises receiving the response from a feeding terminal (24) of the conductor.

7. A method according to claim 6, wherein the step of receiving comprises receiving the response from another feeding terminal (24) of the conductor.

8. A method according to claim 6, wherein the step of receiving comprises receiving the response from the same feeding terminal of the conductor.

9. A method according to any of claims 1 - 5, wherein the step of applying comprises applying the signal of varying frequency to a bushing tap (30) of the inductively operating element providing connectivity to said conductor and the step of receiving comprises receiving the response from the same bushing tap of the inductively operating element.

10. A method according to any previous claim, wherein the frequency range covered by the signal of varying frequency is between 10 kHz and 10 MHz.

11. A method according to any previous claim, wherein the inductively operating element is a transformer (16) and the conductor is a winding (18) of this transformer.

12. A device (10) for determining the change in insulating ability of the insulation provided around a conductor (18) of an inductively operating element (16), which conductor is wound a number of turns (38), and comprising
- a signal generating unit (12) arranged to apply a signal of varying frequency to the conductor of the inductively operating element,
- an analyzing unit (14) arranged to
- receive a frequency response (52) to said signal from said conductor,
- compare the received frequency response (52) with a reference frequency response (50), and
- determine the change in insulating ability based on the comparison.

13. A device (10) according to claim 12, wherein the analyzing unit (14), when being arranged to compare the frequency response with the reference frequency response is arranged to compare a peak (P1') in the received frequency response (52) with a corresponding peak (P1) in the reference frequency response (50) and when being arranged to determine the change in insulating ability is arranged to determine the change in insulating ability based on a difference in shape between the peaks, where both peaks correspond to a resonance frequency caused by the wound conductor.

14. A device (10) according to claim 13, wherein a lower peak value in the peak of the received frequency response than in the corresponding peak of the reference frequency response indicates a degraded insulating ability.

15. A device (10) according to claim 13 or 14, wherein a larger width for a given fraction of the peak value of the peak in the received frequency response in relation to the width of the same fraction of the peak value of the corresponding peak in the reference frequency response indicates a degraded insulating ability.

16. A device (10) according to any of claims 13 - 15, wherein the analyzing unit (14) is arranged to determine the change in insulating ability through comparing more than one peak (P1', P2') in the received frequency response (52) with corresponding peaks (P1, P2) in the reference frequency response (50), where each such peak in a frequency response being compared corresponds to a different resonance frequency.

17. A device (10) according to any of claims 12 - 16, wherein the signal generating unit (12) is arranged to be connected to a feeding terminal (22) of the conductor and also the analyzing unit (14) is arranged to be connected to a feeding terminal (24) of the conductor.

18. A device (10) according to claim 17, wherein the analyzing unit is connected to another feeding terminal (24) of the conductor.

19. A device (10) according to claim 17, wherein the analyzing unit is connected to the same feeding terminal of the conductor.

20. A device (10) according to any of claims 12 - 16, wherein the signal generating unit is arranged to be connected to a bushing tap (30) of the inductively operating element providing connectivity to said conductor and the analyzing unit (14) is arranged to be connected to the same bushing tap of the inductively operating element.

21. A device (10) according to any of claims 12 - 20, wherein the frequency range covered by the signal of varying frequency is between 10 kHz and 10 MHz.

22. A device (10) according to any of claims 12 - 21, wherein the inductively operating element is a transformer (16) and said conductor is a winding (18) of this transformer.

23. A computer program product for determining the change in insulating ability of the insulation provided around a conductor (18) of an inductively operating element (16), which conductor has being wound a number of turns, and comprising
computer program code provided on a computer readable medium and being configured to make a computer perform, when said code is loaded into said computer
- receive, from the conductor (18) of the inductively operating element (16), a frequency response (52) to a signal of varying frequency that has been applied to said conductor of the inductively operating element,
- compare the received frequency response (52) with a reference frequency response (50), and
- determine the change in insulating ability based on the comparison.
